# EUROPEAN PATENT APPLICATION

(11) **EP 2 355 151 A2**
(43) Date of publication of application: **10.08.2011**
(21) Application number: 11152430.2
(22) Date of filing: 27.01.2011
(51) Int. Cl.: H01L 25/075, B41J 2/45, H01L 33/46, H01L 33/14

(54) **Semiconductor light emitting device and image forming apparatus**

(30) Priority: 29.01.2010 JP 2010017985; 29.01.2010 JP 2010017986
(71) Applicant: Oki Data Corporation, Tokyo 108-8551 (JP)
(72) Inventor: Suzuki, Takahito, Gunma 370-0021 (JP); Igari, Tomoki, Gunma 370-0021 (JP); Ogihara, Mitsuhiko, Gunma 370-0021 (JP)
(74) Representative: Betten & Resch

(57) **Abstract**

A semiconductor light emitting device includes laminated semiconductor light emitting elements. A first semiconductor light emitting element is provided on a mounting substrate via a reflection metal layer, and is configured to emit light of first wavelength. A first light-transmissive planarization insulating film is provided covering the first semiconductor light emitting element, and is configured to transmit the light of the first wavelength. A second semiconductor light emitting element is provided on the first semiconductor light emitting element via the first light-transmissive planarization insulating film. The second semiconductor light emitting element is configured to transmit the light of the first wavelength and to emit light of second wavelength. The second semiconductor light emitting element includes a first semiconductor multilayer reflection film facing the first semiconductor light emitting element, which is configured, to transmit the light of the first wavelength and to reflect the light of the second wavelength.

## Description

### BACKGROUND OF THE INVENTION

The present invention relates to a semiconductor light emitting device and an image forming apparatus (such as an image display apparatus) using the light emitting device.

There is known a semiconductor light emitting devices in which a plurality of light emitting elements that emit lights of different wavelengths (for example, red, green and blue lights) are integrated. It is conceivable to construct an image display apparatus by arranging a plurality of such semiconductor light emitting devices in a two-dimensional array.

In this regard, for example, Patent Document No. 1 discloses a semiconductor light emitting device in which a plurality of semiconductor light emitting elements are laminated in a direction perpendicular to light emitting surfaces. If such a semiconductor light emitting device is employed in an image display apparatus, the size of each pixel can be reduced, and therefore a high precision image display apparatus can be obtained.

The semiconductor light emitting device disclosed in Patent Document No. 1 is manufactured as follows. First, a first semiconductor light emitting element is mounted on a substrate. Then, a light-transmissive insulating film is formed on the first semiconductor light emitting element, and a first bonding electrode is formed on the light-transmissive insulating film. Then, a second semiconductor light emitting element having a second bonding electrode on a back surface is bonded onto the first bonding electrode, so that the second semiconductor light emitting element is laminated on the first semiconductor light emitting element.

Patent Document No. 1: Japanese Laid-Open Patent Publication No. 2007-273898

However, in the semiconductor light emitting device manufactured as above, an air layer is formed between the first and second semiconductor light emitting elements. The air layer has a thickness corresponds to a sum of thicknesses of the first and second bonding electrodes and the light-transmissive insulating film.

Therefore, when light is emitted from the back surface of the second semiconductor light emitting element, the light is radiated into the air layer, and is scattered at the surface of the first semiconductor light emitting element, or is absorbed by the first semiconductor light emitting element or the substrate. Thus, the light is not effectively emitted from a light emitting surface of the topmost semiconductor light emitting element. For this reason, it is difficult for the image display apparatus using the semiconductor light emitting devices to provide high brightness.

### SUMMARY OF THE INVENTION

The present invention is intended to solve the above described problems, and an object of the present invention is to provide a semiconductor light emitting device capable of providing high brightness and an image forming apparatus using the semiconductor light emitting device.

According to an aspect of the present invention, there is provided a semiconductor light emitting devices including a plurality of semiconductor light emitting elements in the form of thin films laminated in a direction perpendicular to light emitting surfaces. A first semiconductor light emitting element is provided on a mounting substrate via a reflection metal layer. The first semiconductor light emitting element is configured to emit light of first wavelength. A first light-transmissive planarization insulating film is provided so as to cover the first semiconductor light emitting element. The first light-transmissive planarization insulating film is configured to transmit the light of the first wavelength, and has electrical insulation property. A second semiconductor light emitting element is provided on the first semiconductor light emitting element via the first light-transmissive planarization insulating film. The second semiconductor light emitting element is configured to transmit the light of the first wavelength and to emit light of second wavelength. The second semiconductor light emitting element includes a first semiconductor multilayer reflection film provided on a side facing the first semiconductor light emitting element. The first semiconductor multilayer reflection film is configured to transmit the light of the first wavelength and to reflect the light of the second wavelength.

With such a configuration, lights emitted by the laminated semiconductor light emitting elements can be effectively taken out from a topmost semiconductor light emitting element. Thus, it becomes possible to obtain a semiconductor light emitting device providing high brightness and an image forming apparatus using the semiconductor light emitting device.

According to another aspect of the present invention, there is a provided a semiconductor light emitting device including a plurality of semiconductor light emitting elements in the form of thin films laminated in a direction perpendicular to light emitting surfaces. A first semiconductor light emitting element is provided on a mounting substrate via a reflection metal layer. The first semiconductor light emitting element is configured to emit light of first wavelength. A first light-transmissive planarization insulating film is provided on the first semiconductor light emitting element. The first light-transmissive planarization insulating film is configured to transmit the light of the first wavelength, and has electrical insulation property. A first dielectric multilayer reflection film is provided on the first light-transmissive planarization insulating film. The first dielectric multilayer reflection film is configured to transmit the light of the first wavelength, and has electrical insulation property. A second semiconductor light emitting element is provided on the first light-transmissive planarization insulating film via the first dielectric multilayer reflection film. The second semiconductor light emitting element is configured to transmit the light of the first wavelength and to emit light of second wavelength. The first dielectric multilayer reflection film is configured to reflect the light of the first wavelength and to transmit the light of the second wavelength.

Further scope of applicability of the present invention will become apparent from the detailed description given hereinafter. However, it should be understood that the detailed description and specific embodiments, while indicating preferred embodiments of the invention, are given by way of illustration only, since various changes and modifications within the spirit and scope of the invention will become apparent to those skilled in the art from this detailed description.

### BRIEF DESCRIPTION OF THE DRAWINGS

In the attached drawings:
FIG. 1 is a sectional view showing a semiconductor light emitting device according to the first embodiment of the present invention;
FIG. 2 is a plan view showing the semi conductor light emitting device according to the first embodiment of the present invention;
FIG. 3 is a plan view showing an image display apparatus according to the first embodiment of the present invention;
FIG. 4 is a sectional view showing a semiconductor light emitting device according to the second embodiment of the present invention;
FIG. 5 is a sectional view showing a semiconductor light emitting device according to the third embodiment of the present invention;
FIG. 6 is a plan view showing the semiconductor light emitting device according to the third embodiment of the present invention;
FIG. 7 is a plan view showing an image display apparatus according to the third embodiment of the present invention; and
FIG. 8 is a sectional view showing a semiconductor light emitting device according to the fourth embodiment of the present invention.

### DETAILED DESCRIPTION OF THE PREFERRED EMBODIMENT

Hereinafter, embodiments of the present invention will be described with reference to drawings. The drawings are provided for purposes of explanation only and do not limit the scope of this invention.

### FIRST EMBODIMENT.

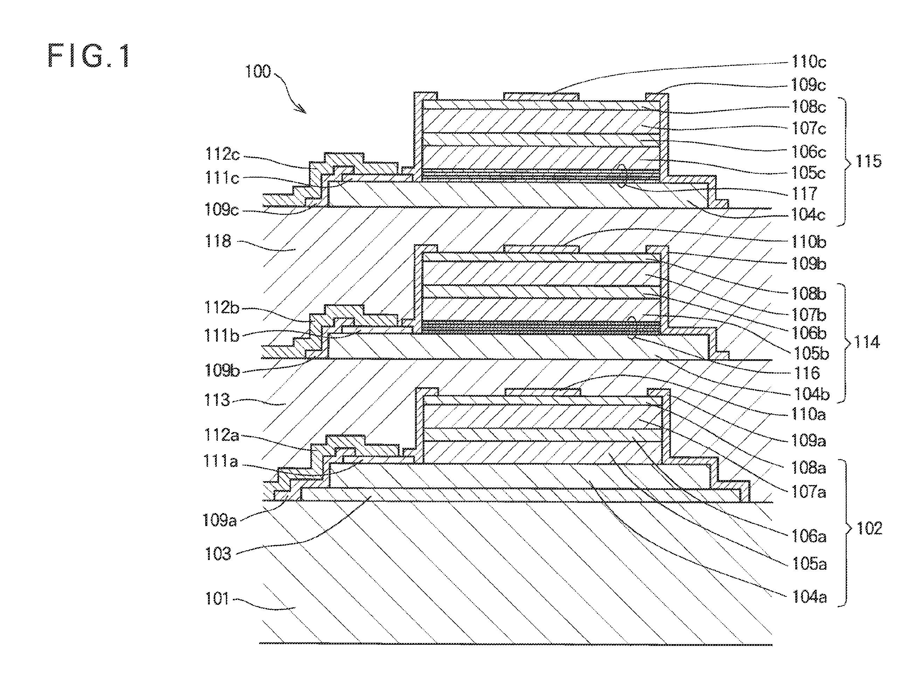

The first embodiment of the present invention will be described with reference to FIGS. 1 through 3.

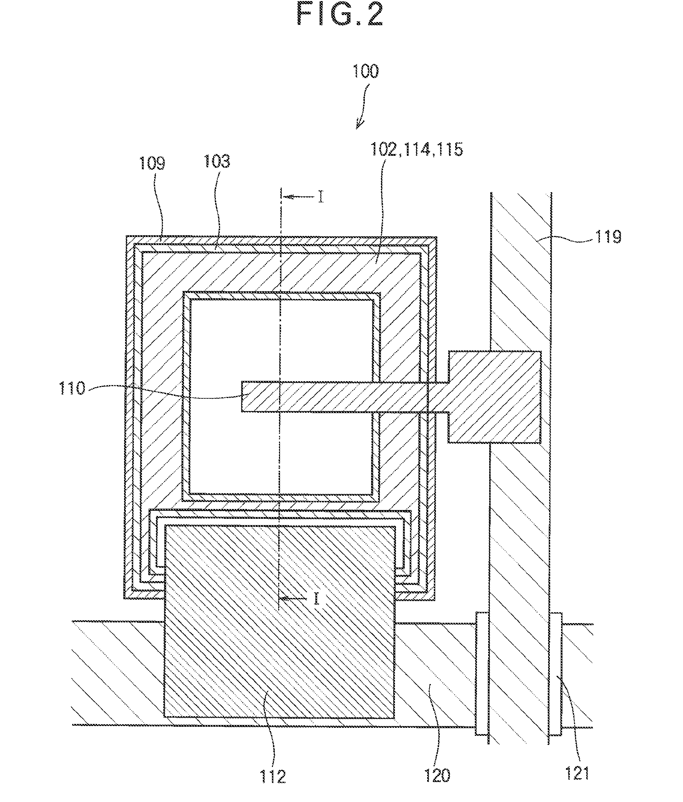

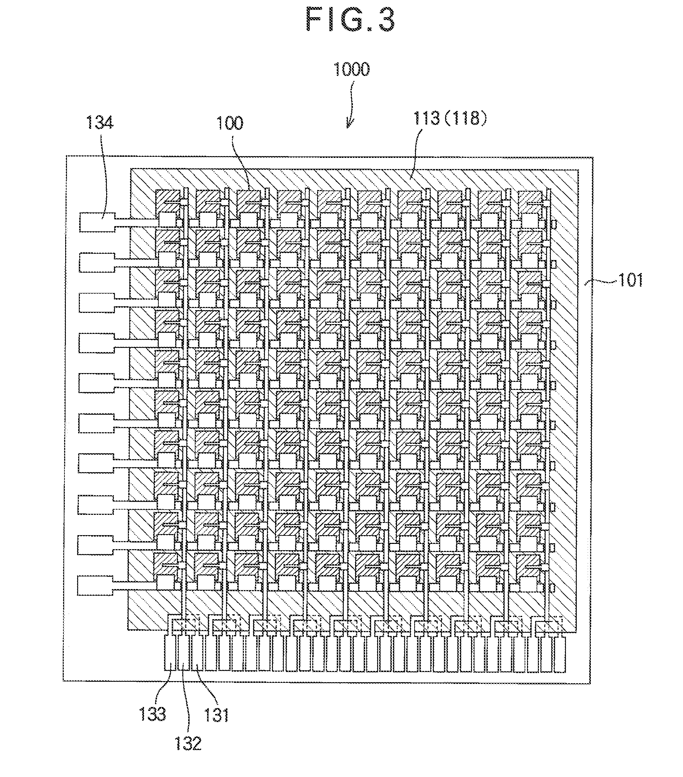

A semiconductor light emitting device 100 of the first embodiment will be described with reference to FIGS. 1 and 2. FIG. 1 is a sectional view showing a semiconductor light emitting device 100 of the first embodiment, taken along line I-I in FIG. 2. FIG. 2 is a plan view showing the semiconductor light emitting device 100 of to the first embodiment. FIG. 3 is a plan view showing an image display apparatus 1000 (as an example of an image forming apparatus) using the semiconductor light emitting devices 100 of the first embodiment. These figures schematically show configurations of the semiconductor light emitting device 100 and the image display apparatus 1000, and are not intended to limit dimensions of respective parts.

As shown in FIG. 1, the semiconductor light emitting device 100 according to the first embodiment has a configuration in which three semiconductor light emitting elements are laminated in a direction perpendicular to light emitting surfaces (i.e., laminated in three-dimensional fashion) on a mounting substrate 101. The image display apparatus 1000 has a configuration in which a plurality of the semiconductor light emitting devices 100 are arranged in matrix as shown in FIG. 3.

In the semiconductor light emitting device 100, first, second and third semiconductor light emitting elements 102, 114 and 115 (respectively in the form of thin films) that emit lights of different wavelengths are laminated in a direction perpendicular to light emitting surfaces of the semiconductor light emitting elements 102, 114 and 115. Among the three semiconductor light emitting elements 102, 114 and 115, the first semiconductor light emitting element 102 is the closet to the mounting substrate 101, and emits light of wavelength λ1. The second semiconductor light emitting element 114 is provided on the first semiconductor light emitting element 102, and emits light of wavelength λ2. The third semiconductor light emitting element 115 is provided on the second semiconductor light emitting element 114, and emits light of wavelength λ3.

Next, laminated structures of the three semiconductor light emitting elements 102, 114 and 115 will be described. The first semiconductor light emitting element 102 includes an N-type contact layer 104a, an N-type clad layer 105a, an active layer (as a light emitting layer) 106a, a P-type clad layer 107a and a P-type contact layer 108a, beginning at the bottom. The second semiconductor light emitting element 114 includes an N-type contact layer 104b, an N-type clad layer 105b, an active layer (as a light emitting layer) 106b, a P-type clad layer 107b and a P-type contact layer 108b, beginning at the bottom. The third semiconductor light emitting element 115 includes an N-type contact layer 104c, an N-type clad layer 105c, an active layer (as a light emitting layer) 106c, a P-type clad layer 107c and a P-type contact layer 108c, beginning at the bottom.

These semiconductor layers can be composed of, for example, AlₐGa_{b}In_{1-a-b}AsₓP_{y}N_{z}Sb_{1-x-y-z} (0≤a≤1, 0≤b≤1, 0≤x≤1, 0≤y≤1, 0≤z≤1) .

These respective semiconductor layers can be formed by epitaxial growth on a substrate such as GaAs, sapphire, InP, quartz or Si using conventional MOCVD (Metal Organic Chemical Vapor deposition) method or MBE (Molecular Beam Epitaxy) method.

The second semiconductor light emitting element 114 further includes a first semiconductor multilayer reflection film 116 formed between the N-type contact layer 104b and the N-type clad layer 105b. The first semiconductor multilayer reflection film 116 reflects the light emitted by the active layer 106b of the second semiconductor light emitting element 114 (or the lights emitted by the active layers 106b and 106c of the semiconductor light emitting elements 114 and 115) only. Further, the first semiconductor multilayer reflection film 116 transmits the light emitted by active layer 106a of the first semiconductor light emitting element 102.

In this regard, the expression "to transmit light" is used to mean "to absorb no or less light".

The third semiconductor light emitting element 115 further includes a second semiconductor multilayer reflection film 117 formed between the N-type contact layer 104c and the N-type clad layer 105c. The second semiconductor multilayer reflection film 117 reflects the light emitted by the active layer 106c of the third semiconductor light emitting element 115 only. Further, the second semiconductor multilayer reflection film 117 transmits the light emitted by active layer 106a of the first semiconductor light emitting element 102, and the light emitted by the active layer 106b of the second semiconductor light emitting element 114.

These semiconductor multilayer reflection films 116 and 117 can be composed of material expressed as, for example, (Alᵣ₁Ga₁₋ᵣ₁)ᵣ₂In₁₋ᵣ₂N (0≤r1≤1, 0≤r2≤1) . These semiconductor multilayer reflection films 116 and 117 can be formed as parts of the semiconductor light emitting elements 114 and 115 musing conventional MOCVD method or MBE method.

Each of the semiconductor multilayer reflection films 116 and 117 (that reflect lights of predetermined wavelengths) is composed of two layers of materials having largely different refractive index, selected from materials expressed as, for example, (Alᵣ₁Ga₁₋ᵣ₁)ᵣ₂In₁₋ᵣ₂N 0≤r1≤1, 0≤r2≤1). A thickness of each layer is set to λ_{T}/4 x (2m+1) where m is an integer. λ_{T} is wavelength when the light (to be reflected) passes each layer. To be more specific, λ_{T} is obtained by dividing the wavelength λ of the light to be reflected by the refractive index n of each layer. Each of the semiconductor multilayer reflection films 116 and 117 includes at least five cycles of combinations (pairs) of these two layers having different refractive indexes.

In the second semiconductor light emitting element 114, the N-type contact layer 104b, the N-type clad layer 105b, the active layer 106b, the P-type clad layer 107b and the P-type contact layer 108b are made of materials that transmit the light emitted from the active layer 106a of the first semiconductor light emitting element 102. In the third semiconductor light emitting element 115, the N-type contact layer 104c, the N-type clad layer 105c, the active layer 106c, the P-type clad layer 107c and the P-type contact layer 108c are made of materials that transmit the lights emitted from the active layers 106a and 106b of the first and second semiconductor light emitting elements 102 and 114.

Next, examples of compositions and wavelengths of the respective semiconductor light emitting elements 102, 114 and 115 will be described, as well as first and second semiconductor multilayer reflection film 116 and 117.

In the first semiconductor light emitting element 102, the P-type contact layer 108a can be composed of GaAs or GaP. Further, the P-type clad layer 107a and N-type clad layer 105a can be composed of Al_{0.5}In_{0.5}P. Furthermore, the active layer 106a can be composed of one or plural quantum-well layer(s) each of which includes a combination of a well layer of (Al_{y1}Ga_{1-y1})₀.₅In_{0.5}P (0≤y1≤0.5) and a barrier layer of (Al_{z1}Ga₁-_{z1})_{0.5}In_{0.5}P (0<zl≤1, y1<zl). Composition ratio of Al in the barrier layer is greater than that in the well layer. The N-type contact layer 104a can be composed of GaAs.

The wavelength λl of the first semiconductor light remitting element 102 is arbitrarily set by controlling the composition ratio of Al in the well layer of the active layer 106a. For example, the wavelength λ1 of the first semiconductor light emitting element 102 is set in a range: 550nn < λl ≤ 650nm (i.e., red wavelength band).

In the second and third semiconductor light emitting elements 114 and 115, the P-type contact layers 108b and 108c and the N-type contact layers 105b and 105c can be composed of GaAs or GaP. Further, the P-type clad layers 107b and 107c and the N-type clad layers 105b and 105c can be composed of Alₓ₂Ga₁₋ₓ₂N (0≤x2≤1). Furthermore, the active layers 106b and 106c can be composed of one or plural quantum-well layer(s) each of which includes a combination of a well layer of In_{y2}Ga_{1-y2}N (0<y2≤1) and a barrier layer of In_{z2}Ga_{1-z2}N (0≤_{z}2<1, z2<y2). Composition ratio of In in the barrier layer is greater than that in the well layer.

The wavelengths λ2 and λ3 of the first and second semiconductor light emitting elements 114 and 115 are arbitrarily set by controlling the composition ratios of In in the well layers of the active layer 106b and 106c. For example, the wavelength λ2 of the second semiconductor light emitting element 114 is set in a range: 480nm < λ2 ≤ 550nm (i.e., green wavelength band), the wavelength λ3 of the third semiconductor light emitting element 115 is set in a range: 450nm ≤3 ≤ 480nm (i.e., blue wavelength band).

Compositions of the semiconductor multilayer reflection films 116 and 117 are as follows. The semiconductor multilayer reflection films 116 and 117 are respectively composed of plural layers expressed as, for example, (Alᵣ₁Ga₁₋ᵣ₁) ᵣ₂In₁₋ᵣ₂N (0≤r1≤1, 0≤r2≤1).

Each of the semiconductor light emitting elements (i.e., thin films) 102, 114 and 115 can be formed by performing epitaxial growth on a growth substrate in such a manner that a sacrificial layer is interposed between the growth substrate and the epitaxially grown layers. The epitaxially grown layers can be separate from the growth substrate by removing the sacrificial layer by chemical etching (i.e., a chemical lift off method). In this regard, it is also possible to separate the epitaxially grown layers from the growth substrate by burning out a boundary between the epitaxially grown layers and the growth substrate using laser (i.e., a laser lift off method). Further, it is also possible to separate the epitaxially grown layers from the growth substrate by grinding the growth substrate.

In this embodiment, each of the semiconductor light emitting elements 102, 114 and 115 is preferably formed to have a thickness of 0.5 µm or less, in consideration of three-dimensional integration of the semiconductor light emitting elements 102, 114 and 115.

A lamination of the semiconductor light emitting device 100 (in which the semiconductor light emitting elements 102, 114 and 115 are laminated) will be described. First, a reflection metal layer 103 (as a thin film) is formed on the surface of the mounting substrate 101. Then, the first semiconductor light emitting element 102 is bonded onto the reflection metal layer 103 by means of intermolecular force or eutectic bonding. Alternatively, the first semiconductor light emitting element 102 can be bonded onto the reflection metal layer 103 using an adhesive agent that transmits the light emitted by the first semiconductor light emitting element 102. The adhesive agent is composed of, for example, polyimide resin, novolac-based resin, SOG, fluorine resin, epoxy resin or the like.

The reflection metal layer 103 is composed of a metal such as Au, Ti, Al or Ag using a conventional sputtering method, vapor deposition method or the like.

The light emitting region of the first semiconductor light emitting element 102 is formed (as a mesa portion) by etching the layers from the P-tyqpe contact layer 108a to the N-type clad layer 105a (using wet etching or dry etching) until the N-type contact layer 104a is exposed.

An N-electrode 111a is formed on the exposed surface of the N-type contact layer 104a using conventional sputtering method, vapor deposition method or the like. The N-electrode 111a is formed of, for example, AuGeNi/Au, or Ti/Al or the like.

An interlayer insulation film 109a is formed to cover etching end surfaces of the mesa portion, and the exposed top surface (and end surfaces) of the N-type contact layer 104a. Openings are formed on the interlayer insulation film 109a through which the N-electrode 111a and the P-type contact layer 108a are respectively connected to an N-electrode connection wiring 112a and a P-electrode connection wiring 110a. The interlayer insulation film 109a is formed of, for example, SiN, SiO₂ or the like using conventional CVD method or sputtering method.

The respective semiconductor light emitting elements 114 and 115 have light emitting regions formed (as mesa portions) by etching the layers from the P-type contact layers 108b and 108c to the N-type clad layers 105b and 105c (using west etching and dry etching) until the N-type contact layers 104b and 104c are exposed. N-electrodes 111b and 111c such as AuGeNi/Au, Ti/Au or the like are formed on exposed surfaces of the N-type contact layers 104b and 104c using conventional sputtering method, vapour deposition method or the like.

Further, interlayer insulation films 109b and 109c of SiN, SiO2 or the like are formed to cover etching surfaces of the mesa portions, the surfaces of the N-type contact layers 104b and 104c, and the etching end surfaces of the N-type contact layers 104b and 104c. The interlayer insulation films 109b and 109c are formed using conventional CVD method or sputtering method. Opening are formed on the interlayer insulation films 109b and 109c through which the N-electrodes 111b and 111c and the P-type contact layers 108b and 108c are connected to N-electrode connection wirings 112b and 112c and P-electrode connection wirings 110b and 110c.

A first light-transmissive planarization insulating film 113 is provided between the first and second semiconductor light emitting elements 102 and 114. A second light-transmissive planarization insulating film 118 is provided between the second and third semiconductor light emitting elements 114 and 115. The first and second light-transmissive planarization insulating films 113 and 118 transmit the lights emitted by the first and second semiconductor light emitting elements 102 and 114. Further, the first and second light-transmissive planarization insulating films 113 and 118 have function to provide planarized surfaces over the first and second semiconductor light emitting elements 102 and 114, and have electrical insulation property.

The first and second light-transmissive planarization insulating films 113 and 118 are formed of, for example, polyimide resin, novolac-based resin, SOG, fluorine resin, epoxy resin or the like, and using spin coating method, spray coating method or the like.

The first and second light-transmissive planarization insulating films 113 and 118 preferably have surface roughness of 5 nm or less, in order to obtain a sufficient bending force for bonding respective semiconductor light emitting elements onto the first and second light-transmissive planarization insulating films 113 and 118.

The second semiconductor light emitting element 114 is bonded onto the first light-transmissive planarization insulating film 113 by means of intermolecular force. The third semiconductor light emitting element 115 is bonded onto the second light-transmissive planarization insulating film 118 by means of intermolecular force. Instead of using intermolecular force, it is also possible to use adhesive agent that transmits the light emitted by the first and second semiconductor light emitting elements 102, 114 and 105.

Next, electrical connection wirings will be described. The P-type contact layers 103a, 108b and 108c of the semiconductor light emitting elements 102, 114 and 115 are connected to an anode common wiring 119 via P-electrode connection wirings 110 (110a, 110b and 110c)as shown in FIG. 2. The N-type contact layers 111a, 111band 111cof the semiconductor light emitting elements 102, 114 and 115 are connected to a cathode common wiring 120 via N-electrode connection wirings 112 (112a, 112b and 112c) as shown in FIG. 2. The anode common wiring 119 and the cathode common wiring 120 are formed commonly for the semiconductor light emitting elements 102, 114 and 115. The lights emitted by the semiconductor light emitting elements 102, 114 and 115 are emitted from a rectangular region on the surface of the third semiconductor light emitting element 115 around the P-electrode connection wiring 110.

The anode common wiring 119 and the cathode common wiring 120 are arranged in matrix, and a common wiring interlayer insulation film 121 is formed therebetween. The respective wirings for the first, second and third semiconductor light emitting elements 102, 114 and 115 are electrically independent from each other. The anode common wiring 119 and the cathode common wiring 120 extend to reach the periphery of the mounting substrate 101.

As shown in FIG. 3, the image display apparatus 1000 of the first embodiment includes a plurality of semiconductor light emitting devices 100. At the periphery of the mounting substrate 101, each of the anode common wirings 119 (FIG. 2) leads to three anode common wiring connection pads 131, 132 and 133 respectively for the first, second and third light emitting element 102, 114 and 115, so as to enable electrical connection with external driving elements or external devices.

Each of the cathode common wirings 120 (FIG. 2) leads to a cathode common wiring connection pad 134 provided at the periphery of the mounting substrate 101, so as to enable electrical connection with external driving elements or external devices.

Next, operation of the semiconductor light emitting device 100 and the image display apparatus 1000 will be described.

As shown in FIG. 1, in the semiconductor light emitting device 100, the light emitted by the active layer 106a. of the first semiconductor light emitting element 102 in a direction toward the mounting substrate 101 is reflected by the reflection metal layer 103 below the first semiconductor light emitting element 102, and proceeds toward a top surface of the first semiconductor light emitting element 102. In contrast, the light emitted by the active layer 106a in a direction away from the mounting substrate 101 proceeds toward the top surface of the first semiconductor light emitting element 102 without being reflected.

The respective layers of the second and third semiconductor light emitting elements 114 and 115 (including the first and second semiconductor multilayer reflection films 116 and 117) are formed of materials that transmit the light emitted by the first semiconductor light emitting element 102. Further, the first and second light-transmissive planarization insulating films 113 and 118 are formed of materials that transmit the light emitted by the first semiconductor light emitting element 102. Therefore, the light emitted by the first semiconductor light emitting element 102 is not absorbed by the layers provided thereabove, and is effectively emitted outside from the top surface of the third semiconductor light emitting element 115.

Further, the light emitted by the active layer 106b of the second semiconductor light emitting element 114 in the direction toward the mounting substrate 101 is reflected by the first semiconductor multilayer reflection film 116, and proceeds toward the top surface of the second semiconductor light emitting element 114. In contrast, the light emitted by the active layer 106b in the direction away from the mounting substrate 101 proceeds to the top surface of the second semiconductor light emitting element 114 without being reflected.

The respective layers of the third semiconductor light emitting element 115 (including the second semiconductor multilayer reflection film 117) and the second light-transmissive planarization insulating film 118 are formed of materials that transmit the light emitted by the first semiconductor light emitting element 114. Therefore, the light emitted by the second semiconductor light emitting element 114 is not absorbed by the layers provided thereabove, and is effectively emitted outside from the top surface of the third semiconductor light emitting element 115.

It is preferable that the first semiconductor multilayer reflection film 116 is configured to reflect the light emitted by the third semiconductor light emitting element 11.5, as well as the light emitted by the second semiconductor light emitting element 114. With such a structure, the first semiconductor multilayer reflection film 116 can effectively reflect the lights that have not been reflected by the second semiconductor multilayer reflection film 117.

Furthermore, the light emitted by the active layer 106c of the third semiconductor light emitting element 115 in the direction toward the mounting substrate 101 is reflected by the second semiconductor multilayer reflection film 117, and proceeds toward the top surface of the third semiconductor light emitting element 115. In contrast, the light emitted by the active layer 106c in the direction away from the mounting substrate 101 proceeds to the top surface of the third semiconductor light emitting element 115 without being reflected. Therefore, the light emitted by the third semiconductor light emitting element 115 is effectively emitted outside from the top surface thereof.

As described above, according to the first embodiment of the present invention, the lights emitted by the laminated semiconductor light emitting elements (in the form of thin films) can be effectively taken out from the top surface of the topmost semiconductor light emitting element. Therefore, it becomes possible to obtain the semiconductor light emitting device 100 and the image display apparatus 1000 providing high brightness.

### SECOND EMBODIMENT.

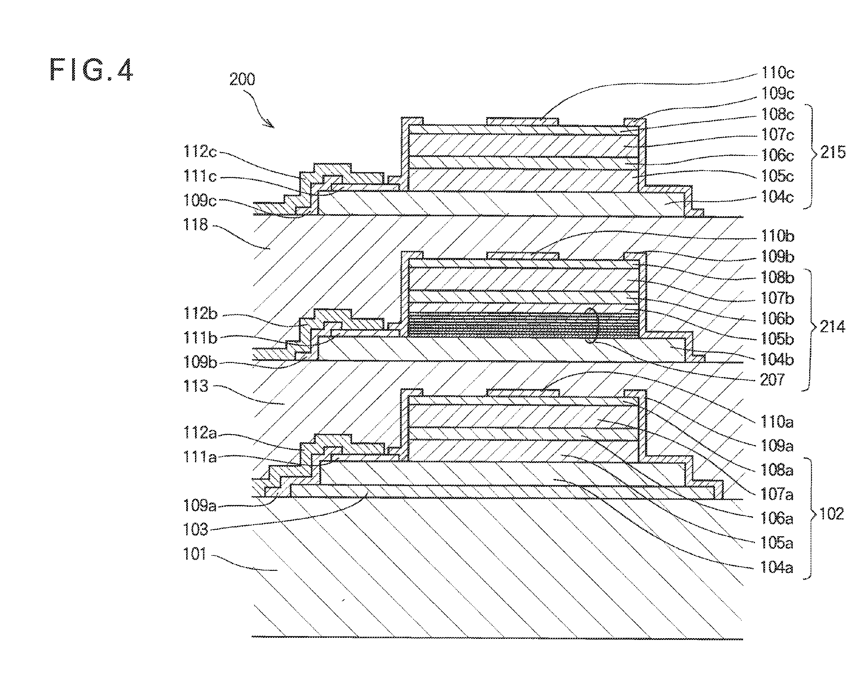

The second embodiment of the present invention will be described with reference to FIG. 4.

FIG. 4 is a sectional view showing a semiconductor light emitting device 200 of the second embodiment.

Unlike the semiconductor light emitting device 100 of the first embodiment, the semiconductor light emitting device 200 of the second embodiment has a wide-range semiconductor multilayer reflection film 207 provided directly below the N-type clad layer 105b. (i.e., between the N-contact layer 104b and the N-type clad layer 105b) of the second semiconductor light emitting element 214.

The semiconductor multilayer reflection film 207 is composed of semiconductor multilayer film that reflects the lights emitted by the second and third semiconductor light emitting elements 214 and 215 in the direction toward the mounting substrate 101, and that transmits the light emitted by the first semiconductor light emitting element 102.

Further, unlike the semiconductor light emitting device 100 of the first embodiment, the third semiconductor light emitting element 215 of the semiconductor light emitting device 200 has no semiconductor multilayer reflection film.

The second and third semiconductor light emitting elements 214 and 215. of the second embodiment are the same as semiconductor light emitting elements 114 and 115 (FIG. 1) of the first embodiment in other respects.

With such a configuration, both of the light emitted by the second semiconductor light emitting element 214 in the direction toward the mounting substrate 101 and the light emitted by the third semiconductor light emitting element 215 in the direction toward the mounting substrate 101 can be reflected by the wide-range semiconductor multilayer reflection film 207 provided in the second semiconductor light emitting element 214.

Therefore, it becomes possible to eliminate the second semiconductor multilayer reflection film 117 (FIG. 1) from the third semiconductor multilayer reflection film 215.

Moreover, even when the wavelength of the light emitted by the second semiconductor light emitting element 214 is close to the wavelength of the light emitted by the third semiconductor light emitting element 215, the light emitted by the second semiconductor light emitting element 214 in the direction away from the mounting substrate (i.e. toward the third semiconductor light emitting element 215) can passes through the third semiconductor light emitting element 215 without being reflected thereat. Therefore, the light can be effectively taken out from the top surface of the semiconductor light emitting device 200.

As described above, according to the second embodiment of the present invention, the lights emitted by the laminated semiconductor light emitting elements (in the form of thin films) can be effectively taken out from the top surface of the topmost semiconductor light emitting element, and therefore it becomes possible to obtain the semiconductor light emitting device and the image display apparatus providing high brightness.

Further, with the provision of the wide-range semiconductor multilayer reflection film in the second semiconductor light emitting element, the structure of the third semiconductor light emitting element can be simplified, and the light can be further effectively taken out from the semiconductor light emitting device.

### THIRD EMBODIMENT.

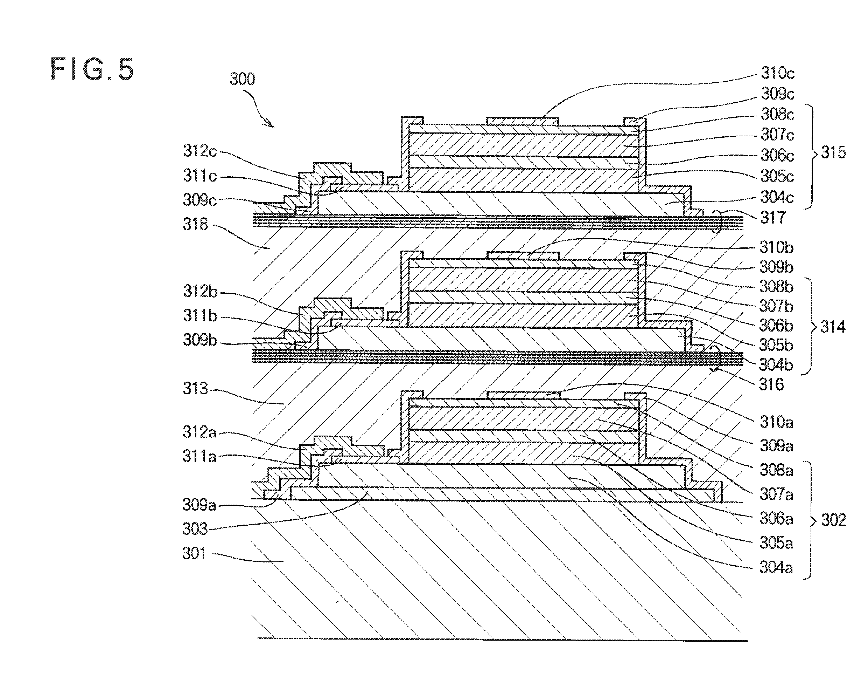

The third embodiment of the present invention will be described with reference to FIGS. 5 through 7.

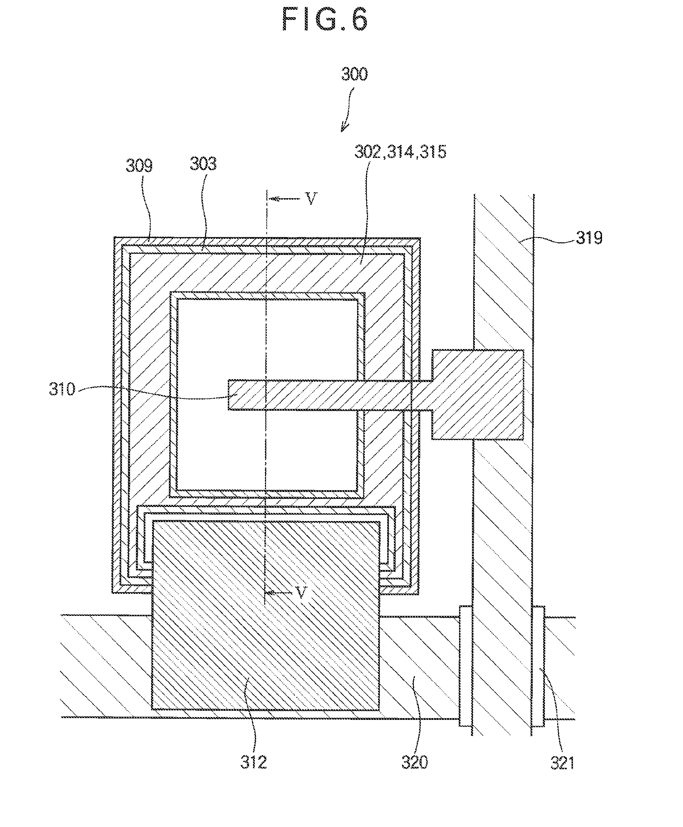

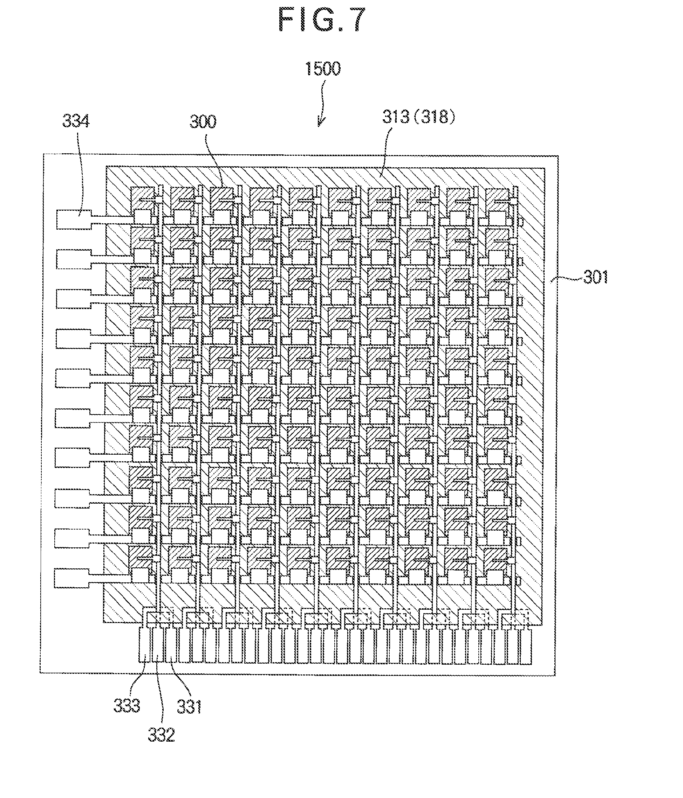

A semiconductor light emitting device 300 of the third embodiment will be described with reference to FIGS. 5. and 6. FIG. 5 is a sectional view showing a semiconductor light emitting device 300 of the third embodiment, taken along line V-V in FIG. 6. FIG. 6 is a plan view showing the semiconductor light emitting device 300 of the third embodiment. FIG. 7 is a plan view showing an image display apparatus 1500 using the semiconductor light emitting devices 300 of the third embodiment. These figures schematically show configurations of the semiconductor light emitting device 300 and the image display apparatus 1500, and are not intended to limit dimensions of respective parts.

As shown in FIG. 5, the semiconductor light emitting device 300 according to the third embodiment has a configuration in which three semiconductor light emitting elements are laminated in a direction perpendicular to light emitting surfaces (i.e., laminated in three-dimensional fashion) on a mounting substrate 301. The image display apparatus 1500 has a configuration in which a plurality of the semiconductor light emitting devices 300 are arranged in a matrix as shown in FIG. 7.

In the semiconductor light emitting device 300, first, second and third semiconductor light emitting elements 302, 314 and 315 (respectively in the form of thin films) that emit lights of different wavelengths are laminated in a direction perpendicular to light emitting surfaces of the semiconductor light emitting elements 302, 314 and 315. Among the three semiconductor light emitting elements 302, 314 and 31.5, the first semiconductor light emitting element 302 is the closest to a mounting substrate 301, and emits light or wavelength λ1. The second semiconductor light emitting element 314 is provided on the first semiconductor light emitting element 302, and emits light of wavelength λ2. The third semiconductor light emitting element 315 is provided on the second semiconductor light emitting element 314, and emits light of wavelength λ3.

Laminated structures of the three semiconductor light emitting elements 302, 314 and 315 will be described. The first semiconductor light emitting element 302 includes an N-type contact layer 304a, an N-type clad layer 305a, an active layer (as a light emitting layer) 306a, a P-type clad layer 307a and a P-type contact layer 308a, beginning at the bottom. The second semiconductor light emitting element 314 includes an N-type contact layer 304b, an N-type clad layer 305b, an active layer (as a light emitting layer) 306b, a P-type clad layer 307b and a P-type contact layer 308b, beginning at the bottom. The third semiconductor light emitting element 315 includes an N-type contact layer 304c, an N-type clad layer 305c, an active layer. (as a light emitting layer) 306c, a P-type clad layer 307c and a P-type contact layer 308c, beginning at the bottom.

These semiconductor layers can be composed of, for example, AlₐGa_{b}In_{1a-b}AsₓP_{y}N_{z}Sb_{1-y-z}, (0≤a≤1 0≤b≤1 0≤x≤1 0≤y≤1 0≤z≤1).

These semiconductor layers can be formed by epitaxial growth on a substrate such as GaAs, sapphire, InP, quartz or Si using conventional MOCVD (Metal Organic Chemical Vapor deposition) method or MBE (Molecular Beam Epitaxy) method.

All of the layers of the second semiconductor light emitting element 314 are composed of materials that transmit the light emitted by the first semiconductor light emitting element 302. All of the layers of the third semiconductor light emitting element 315 are composed of materials that transmit the lights emitted by the first and second semiconductor light emitting elements 302 and 314. In this regard, the expression "to transmit light" is used to mean "to absorb no or less light".

Next, examples of compositions and wavelengths of the semiconductor light emitting elements 302, 314 and 315 will be described.

In the first semiconductor light emitting element 302, the P-type contact layer 308a can be composed of GaAs or GaP. Further, the P-type clad layer 307a and N-type clad layer 305a can be composed of Al_{0.5}In_{0.5}P. Furthermore, the active layer 306a can be composed of one or plural quantum-well layer(s) each of which includes a combination of a well layer of (Aly₁Ga_{1-y1})_{0.5}In_{0.5}P (0≤y≤0.5) and a barrier layer of (Al_{z1}Ga_{1-z1}) _{0.50}In_{0.5}P (0<z1≤1, y1<z1). Composition ratio of Al in the barrier layer is greater than that in the well layer. The N- type contact layer 304a can be composed of GaAs.

The wavelength λ1 of the first semiconductor light emitting element 302 is arbitrarily set by controlling the composition ratio of Al in the well layer of the active layer 306a. For example, the wavelength λ1 of the first semiconductor light emitting element 302 is set in a range: 550nm < λ1 ≤ 650nm (i.e., red wavelength band).

In the second and third semiconductor light emitting elements 314 and 315, the P-type contact layers 308b and 308c and the N-type contact layers 305b and 305c can be composed of GaAs or GaP. Further, the P-type clad layers 307b and 307c and the N-type clad layers 305b and 305c can be composed of Alₓ₂Ga₁₋ₓ₂N (0≤x2≤1) Furthermore, the active layers 306b and 306c can be composed of one or plural quantum-well layer(s) each of which includes a combination of a well layer of In_{y2}Ga_{1-y2}N (0≤y2≤1) and a barrier layer of In_{z2},Ga_{1-z2}N (0≤_{z2}<1, z2<y2). Composition ratio of In in the barrier layer is greater than that in the well layer.

The wavelengths λ2 and λ3 of the first and second semiconductor light emitting elements 314 and 315 are arbitrarily set by controlling the composition- ratio of In in the well layers of the active layer 306b and 306c. For example, the wavelength λ2 of the second semiconductor light emitting element 314 is set in a range: 480nm < λ2 ≤ 550nm (i.e., green wavelength band), the wavelength λ3 of the third semiconductor light emitting element 315 is set in a range: 450nm ≤ λ3 ≤ 480nm (i.e., blue wavelength band).

Each of the semiconductor light emitting elements (thin films) 302, 314 and 315 can be formed by performing epitaxial growth on a growth substrate in such a manner that a sacrificial layer is interposed between the growth substrate and the epitaxially grown layers. The epitaxially grown layers can be separated from the growth substrate by removing the sacrificial layer by chemical etching (i.e., a chemical lift off method). In this regard, it is also possible to separate the epitaxially grown layers from the growth substrate by burning out a boundary between the epitaxially grown layers and the growth substrate using laser (i.e., a laser lift off method). Further, it is also possible to separate the epitaxially grown layers from the growth substrate by grinding the growth substrate.

In this embodiment, each of the semiconductor light emitting elements 302, 314 and 315 is preferably formed to have a thickness of 0.5 µm or less, in consideration of three-dimensional integration of the semiconductor light emitting elements 302, 314 and 315.

The respective semiconductor light emitting elements 302, 314 and 315 have light emitting regions (as mesa portions) formed by etching the layers from the P-type contact layers 308a, 308b and 308c to the N-type clad layers 305a, 305b and 305c (using wet etching or dry etching) until the N-type contact layers 304a, 304b and 304c are exposed. N-electrodes 311a, 311b and 311c such as AuGeNi/Au, Ti/Au or the like are formed on exposed surfaces of the N-type contact layers 304a, 304b and 304c using conventional sputtering method, vapor deposition method or the like.

Further, interlayer insulation films 309a, 309b and 309c of SiN, SiO₂ or the like are formed to cover etching surfaces of the mesa portions, the surfaces of the N-type contact layers 304a, 304b and 304c, and the etching surfaces of the N-type contact layers 304a, 304b and 304c.

Furthermore, openings are formed on the interlayer insulation films 309a, 309b and 309c through which the N-electrodes 311a, 311b and 311c and the P-type contact layers 308a, 308b and 308c are connected to N-electrode connection wirings 312a, 312b and 312c and P-electrode connection wirings 310a, 310b and 310c.

The interlayer insulation films 309a, 309b and 309c are formed using conventional CVD method or sputtering method. Material and thicknesses of the interlayer insulation films 309a, 309b and 309c are set as to transmit the lights emitted by the semiconductor light emitting elements 302, 314 and 315.

A lamination of the semiconductor light emitting device 300 (in which the semiconductor light emitting elements 302, 314 and 315 are laminated) will be described. First, a reflection metal layer 303 (as a thin film) is formed on the surface of the mounting substrate 301. The substrate 301 has electrical insulation property or has an insulating thin layer on a top surface thereof. The reflection metal layer 303 is composed of a metal with excellent optical reflection property such as Au, Ti, Al or Ag. using conventional sputtering method, vapor deposition method or the like.

Then, the first semiconductor light emitting element 302 is bonded onto the reflection metal layer 303 by means of intermolecular force or eutectic bonding. Alternatively, the first semiconductor light emitting element 302 can be bonded onto the reflection metal layer 303 using adhesive agent that transmits the light of the wavelength λ1 emitted by the first semiconductor light emitting element 302. The adhesive agent is composed of, for example, polyimide resin, novolac-based resin, SOG, fluorine-based resin, epoxy resin or the like.

A first light-transmissive planarization insulating film 313 is provided between the first and second semiconductor light emitting elements 302 and 314. The first light-transmissive planarization insulating film 313 transmits the lights of wavelengths λ1 and λ2 emitted by first and second semiconductor light emitting elements 302 and 314. The first light-transmissive planarization insulating film 313 has function to provide a planarized surface over the first semiconductor light emitting element 302, and has electrical insulation property. A second light-transmissive planarization insulating film 318 is provided between the second and third semiconductor light emitting elements 314 and 315. The second light-transmissive planarization insulating film 318 transmits the lights of wavelengths λ1, λ2 and λ3 emitted by the first, second and third semiconductor light emitting elements 302, 314. and 315. The second light-transmissive planarization insulating film 318 has function to provide a planarized surface over the second semiconductor light emitting elements 314, and has electrical insulation property.

The first and second light-transmissive planarization insulating films 313 and 318 are composed of, for example, polyimide resin, novolac-based resin, SOG, fluorine resin, epoxy resin or the like, using a spin coating method, spray coating method or the like.

A first dielectric layer reflection film 316 is provided between the first light-transmissive planarization insulating film 113 and the second semiconductor light emitting element 314. The first dielectric multilayer reflection film 316 reflects the light of the wavelength λ2, and transmits the light of the wavelength λ1. A second dielectric multilayer reflection film 317 is provided between the second light-transmissive planarization insulating film 318 and the third semiconductor light emitting element 315. The second dielectric multilayer reflection film 317 reflects the light of the wavelength X3, and transmits the lights of the wavelengths λ1 and λ2.

The first and second dielectric multilayer reflection film 316 and 317 are formed of dielectric material such as SiO₂, SiN, TiO₂, Nb₂O₅, Al₂O₃, ZrO₂, Y₂O₃, MgF₂, Ta₂O₅ or the like and using conventional sputtering method, plasma CVD method or the like.

In order that the first and second dielectric multilayer reflection films 316 and 317 reflect the lights of specific wavelength A2 or X3, the first and second dielectric multilayer reflection films 316 and 317 are composed of for example, two kinds of dielectric materials having largely different refractive indexes selected among of the above described dielectric materials.

The first dielectric multilayer reflection film 316 (reflecting the light of the wavelength λ2) is formed of dielectric layers A and B respectively having the thicknesses dₐ-_{ref} and d_{b-ref} The thickness d_{a-ref} of the dielectric layer A is determined to be an odd multiple of a value of a propagation wavelength λA2 divided by 4. The propagation wavelength λA2 is wavelength when the light of the wavelength λ2 propagates through the dielectric layer A. The thickness d_{b-ref} of the dielectric layer B is determined to be an odd multiple of a value of a propagation wavelength λB2 divided by 4. The propagation wavelength λB2 is wavelength when the light of the wavelength λ2 propagates through the dielectric layer B.

The second dielectric multilayer reflection film 317 (reflecting the light of the wavelength λ3) is formed of dielectric layers C and D respectively having the thicknesses d_{c-ref} and d_{d-ref}. The thickness d_{c-ref} of the dielectric layer C is determined to be an odd multiple of a value of a propagation wavelength λC3 divided by 4. The propagation wavelength λC3 is wavelength when the light of the wavelength λ3 propagates through the dielectric layer C. The thickness d_{d-ref} of the dielectric layer D is determined to be an odd multiple of a value of a propagation wavelength λD3 divided by 4. The propagation wavelength λD3 is wavelength when the light of the wavelength λ3 propagates through the dielectric layer D.

Additionally, the first dielectric multilayer reflection film 316 is configured to transmit the light of the wavelength λ1, as well as to reflect the light of the wavelength λ2. For this purpose, the above described dielectric layers A and B of the first dielectric multilayer reflection film 316 preferably have thicknesses dₐ₋ₜᵣₐₙₛ and d_{b-trans.} The thickness dₐ₋ₜᵣₐₙₛ of the dielectric layer A is determined to be an integral multiple of a value of the propagation wavelength λA1 (i.e., the wavelength when the light of the wavelength λ1 propagates through the dielectric layer A) divided by 2. The thickness d_{b-trans} of the dielectric layer B is determined to be an integral multiple of a value of the propagation wavelength λB1 (i.e., the wavelength when the light of the wavelength λ1 propagates through the dielectric layer B) divided by 2.

In this regard, if it is difficult to make the thicknesses dₐ₋ₜᵣₐₙₛ and d_{b-trans} for transmitting the light of the wavelength λ1 be the same as the thicknesses d_{a-ref} and d_{b-ref} for reflecting the light of the wavelength λ2, the thicknesses of the dielectric layers A and B are respectively set to an intermediate thickness (or its vicinity) between the thicknesses dₐ₋ₜᵣₐₙₛ and d_{a-ref} and an intermediate thickness between the thicknesses d_{b-trans} and d_{b-ref} so as to most effectively transmit the light of the wavelength λ1 and to most effectively reflect the light of the wavelength λ2.

Moreover, the second dielectric multilayer reflection film 317 is configured to transmit the lights of the wavelengths λ1 and λ2, as well as to reflect the light of the wavelength λ3. For this purpose, the above described dielectric layers C and D of the second dielectric multilayer reflection film 31.7 preferably have thicknesses d_{c-trans} and d_{d-trans}. The thickness d_{c-trans} of the dielectric layer C is set to be an intermediate thickness (or its vicinity) between an integral multiple of a value of the propagation wavelength λC1 (i.e., the wavelength when the light of the wavelength λ1 propagates through the dielectric layer. C) divided by 2 and an integral multiple of a value of the propagation wavelength λC2 (i.e., the wavelength when the light of the wavelength λ2 propagates through the dielectric layer C) divided by 2. The thickness d_{d-trans} of the dielectric layer D is set to be an intermediate thickness (or its vicinity) between an integral multiple of a value of the propagation wavelength λD1 (i.e., the wavelength when the light of the wavelength λ1 propagates through the dielectric layer D) divided by 2 and an integral multiple of a value of the propagation wavelength λD2 (i.e., the wavelength when the light of the wavelength X2 propagates through the dielectric layer D) divided by 2.

In this regard, if it is difficult to make the thicknesses d_{c-trans} and d_{d-trans} for transmitting the lights of the wavelengths λ1 and λ2 be the same as the thicknesses d_{c-ref} and d_{d-ref} for reflecting the light of the wavelength λ3, the thicknesses of the dielectric layers C and D are respectively set to an intermediate thickness (or its vicinity) between the thicknesses d_{c-trans} and d_{c-ref} and an intermediate thickness (or its vicinity) between the thicknesses d_{d-trans} and d_{d-ref} so as to most effectively transmit the lights of the wavelengths λ1 and λ2 and to most effectively reflect the light of the wavelength λ3.

Each of the first and second dielectric multilayer reflection films 316 and 317 preferably includes at least two cycles of combinations of these dielectric layers having largely different refractive indexes.

The first and second dielectric multilayer reflection films 316 and 317 preferably have surface roughness of 5 nm or less, in order to obtain a sufficient bonding force for integrating respective semiconductor light emitting elements 314 and 315 thereon.

The first and second light-transmissive planarization insulating films 313 and 318 and the first and second dielectric multilayer reflection films 316 and 317 are formed on a region wider than an image display area of the image display apparatus 1500 (FIG. 7), The first and second light-transmissive planarization insulating films 313 and 318 and the first and second dielectric multilayer reflection films 316 and 317 are partially removed at regions where the anode common wiring connection pads 331, 332 and 333 and the cathode common wiring 334 (FIG. 7) are formed for electrical connection with external driving elements or external devices.

The second and third semiconductor light emitting elements 314 and 315 can be bonded onto the first and second dielectric multilayer reflection films 316 and 317 by means of intermolecular force between the second semiconductor light emitting element 314 and the first dielectric multilayer reflection film 316 and between the third semiconductor light emitting element 315 and the second dielectric multilayer reflection film 318. Alternatively, it is possible to use adhesive agent that transmits the lights, of the wavelengths λ1, λ2 and λ3. The adhesive agent is composed of, for example, polyimide resin, novolac-based resin, SOG, fluorine-based resin, epoxy resin or the like.

Next, electrical connection wirings will be described. The P-type contact layers 308a, 308b and 308c of the semiconductor light emitting elements 302, 314 and 315 are connected to an anode common wiring 319 via P-electrode connection wirings 310 (310a, 310b and 310c) as shown in FIG. 6. The N-electrodes 311a, 311b and 311c of the semiconductor light emitting elements 302, 314 and 315 are connected to a cathode common wiring 320 via N-electrode connection wirings 312 (312a, 312b and 312c) as shown in FIG. 6. The anode common wiring 31.9 and the cathode common wiring 320 are formed commonly for the semiconductor light emitting elements 302, 314 and 315. The lights emitted by the semiconductor light emitting elements 302, 314 and 315 are emitted from a rectangular region on the surface of the third semiconductor light emitting element 315 around the P-electrode connection wiring 310.

The anode common wiring 319 and the cathode common wiring 320 are arranged in matrix, and a common wiring interlayer insulation film 321 is formed therebetween. The respective wirings for the first, second and third semiconductor light emitting elements 302, 314 and 315 are electrically independent from each other. The anode common wiring 319 and the cathode common wiring 320 extend to reach the periphery of the mounting substrate 301.

As shown in FIG. 7, the image display apparatus 1500 of the second embodiment includes a plurality of semiconductor light emitting devices 300. At the periphery of the mounting substrate 301, each of the anode common wirings 319 (FIG. 6) leads to three anode common wiring connection pads 131, 132 and 133 respectively for the first, second and third light emitting element 302, 314 and 315, so as to enable electrical connection with external driving elements or external devices.

Each of the cathode common wirings 320 (FIG. 6) leads to a cathode common wiring connection pad 334 provided at the periphery of the mounting substrate 301, so as to enable electrical connection with external driving elements or external devices.

Next, operation of the semiconductor light emitting device 300 and the image display apparatus 1500 will be described.

As shown in FIG. 5, in the semiconductor light emitting device 300, the light of the wavelength λ1 emitted by the active layer 306a of the first semiconductor light emitting element 302 in a: direction toward the mounting substrate 301 is reflected by the reflection metal layer 303 below the first semiconductor light emitting element 302, and proceeds toward a top surface of the first semiconductor light emitting element 302. In contrast, the light of the wavelength λ1 emitted by the active layer 306a in a direction away from the mounting substrate 301 proceeds toward the top surface of the first semiconductor light emitting element 302 without being reflected.

The respective layers of the first and second light-transmissive planarization insulating films 313 and 318 and the second and third semiconductor light emitting elements 314 and 315 are formed of materials that transmit the light of the wavelength λ1 emitted by the first semiconductor light emitting element 302. Further, the first and second dielectric multilayer reflection films 316 and 317 are formed of materials that transmit the light of the wavelength λ1 emitted by the first semiconductor light emitting element 302.

Therefore, the light of the wavelength λ1 emitted by the first semiconductor light emitting element 302 is not absorbed by the layers provided thereabove, and is effectively emitted outside from the top surface of the third semiconductor light emitting element 315.

Further, the light of the wavelength λ2 emitted by the active layer 306b of the second semiconductor light emitting element 314 in the direction toward the mounting substrate 301 is reflected by the first dielectric multilayer reflection film 316, and proceeds toward the top surface of the second semiconductor light emitting element 314. In contrast, the light of the wavelength λ2 emitted by the active layer 306b in the direction away from the mounting substrate 301 proceeds to the top surface of the second semiconductor light emitting element 314 without being reflected.

The respective layers of the second light-transmissive planarization insulating film 318, the third semiconductor light emitting element 315 and the second dielectric multilayer reflection film 317 are formed of materials that transmit the light of the wavelength λ2 emitted by the first semiconductor light emitting element 314.

Therefore, the light of the wavelength λ2 emitted by the second semiconductor light emitting element 314 is not absorbed by the layers provided thereabove, and is effectively emitted outside from the top surface of the third semiconductor light emitting element 315.

Furthermore, the light of the wavelength λ3 emitted by the active layer 306c of the third semiconductor light emitting element 315 in the toward the mounting substrate 301 is reflected by the second dielectric multilayer reflection film 317, and proceeds toward the top surface of the third semiconductor light emitting element 315. In contrast, the light of the wavelength λ3 emitted by the active layer 306c in the direction away from the mounting substrate 301 proceeds to the top surface of the third semiconductor light emitting element 315 without being reflected.

Therefore, the light of the wavelength λ3 emitted by the third semiconductor light emitting element 315 is effectively emitted outside from the top surface of the third semiconductor light emitting element 315.

Further, since each of the first and second dielectric multilayer reflection films 316 and 317 is formed of combination of dielectric layers having largely different refractive indexes, high reflection property can be obtained even when the number of cycles of combination of the dielectric layers is small. Therefore, the thickness of each dielectric multilayer reflection film can be reduced.

Furthermore, the first and second dielectric multilayer reflection films 316 and 31.7 have insulating property, and function to electrically insulate the respective wirings (i.e., the anode common wirings 319, the cathode common wirings 320) arranged in matrix for the respective semiconductor light emitting elements 302, 314 and 315. Therefore, electrical stabilization of the semiconductor light emitting elements 302, 314 and 315 is enhanced.

As described above, according to the third embodiment of the present invention, the lights emitted by the laminated plural semiconductor light emitting elements can be effectively taken out from the top surface of the topmost semiconductor light emitting element. Further, respective wirings can be electrically insulated by the dielectric multilayer reflection films. Therefore, it becomes possible to obtain the semiconductor light emitting device and the image display apparatus providing high brightness.

### FOURTH EMBODIMENT.

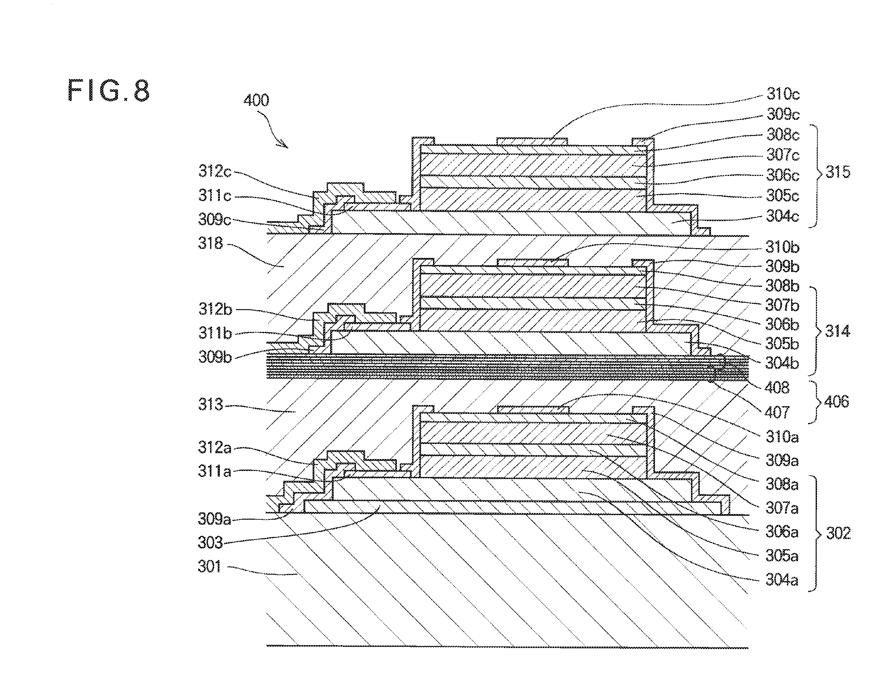

The fourth embodiment of the present invention will be described with reference to FIG. 8.

FIG. 8 is a sectional view showing a semiconductor light emitting device 400 of the fourth embodiment.

Unlike the semiconductor light emitting device 300 of the third embodiment, the semiconductor light emitting device 400 of the fourth embodiment has a wide-range dielectric multilayer reflection film 406 provided between the second semiconductor light emitting element 314 and the first light-transmissive planarization insulating film 313. Further, the semiconductor light emitting device 400 has a configuration in which the third semiconductor light emitting element 315 is formed directly on the second light-transmissive planarization insulating film 318.

The wide-range dielectric multilayer reflection film 406 is configured to reflect the light of the wavelength λ2 emitted by the active layer 306b of the second semiconductor light emitting element 314 toward the mounting substrate 301, and to reflect the light of the wavelength λ3 emitted by the active layer 306c of the third semiconductor light emitting element 315 toward the mounting substrate 301. Further, the wide-range dielectric multilayer reflection film 406 is configured to effectively transmit the light of the wavelength λ1 emitted by the active layer 306a of the first semiconductor light emitting element 302 toward the second semiconductor light emitting element 314.

In order that the wide-range dielectric multilayer reflection film 406 has such an optical property, the wide-range dielectric multilayer reflection film 406 is composed of a first dielectric multilayer reflection film 407 and a second dielectric multilayer reflection film 408.

The first dielectric multilayer reflection film 407 is composed of at least two cycles of combinations of dielectric layers A and B having largely different refractive indexes selected among dielectric materials such as SiO₂, SiN, TiO₂, Nb₂O₅ Al₂O₃, ZrO₂, Y₂O₃, MgF₂, Ta₂O₅ or the like. The dielectric layers A and B have the thicknesses which are determined to be odd multiples of values of propagation wavelengths λA2 and λB2 respectively divided by 4. The propagation wavelengths λA2 and λB2 are wavelengths when the light of the wavelength λ2 propagates through the respective dielectric layers A and B. The second dielectric multilayer reflection film 408 is composed of at least two cycles of combinations of dielectric layers C and D having largely different refractive indexes selected among dielectric materials such as SiO₂, SiN, TiO₂, Nb₂O₅, AL₂O₃, ZrO₂, Y₂O₃, MgF₂, Ta₂O₅ or the like. The dielectric layers C and D have the thicknesses which are determined to be odd multiples of values of propagation wavelengths λC3 and λD3 respectively divided by 4. The propagation wavelengths λC3 and λD3 are wavelengths when the light of the wavelength λ3 propagates through the respective dielectric layers C and D.

In this regard, it is possible that materials of the dielectric layers A and B of the first dielectric multilayer reflection film 207 are the same as those of the dielectric layers C and D of the second dielectric multilayer reflection film 408. Further, if the thicknesses of the dielectric layers A and B of the first dielectric multilayer reflection film 407 are controlled so as to reflect the lights of the wavelengths λ2 and λ3, it is also possible to eliminate the second dielectric multilayer reflection film 408.

Further, the respective dielectric layers of the wide-range dielectric multilayer reflection film 406 are configured to effectively transmit the light of the wavelength λ1 emitted by the first semiconductor light emitting element 302. For this purpose, the above described dielectric layers A, B, C and D preferably have thicknesses which are determined to be integral multiples of values of the propagation wavelengths λA1, λB1, λC1 and λD1 (i.e., the wavelengths when the light of the wavelength λ1 propagates through the respective dielectric layers A, B, C and D) divided by 2.

If it is difficult to make the thicknesses of the dielectric layers for transmitting the light of the wavelength λ1 be the same as the thicknesses for reflecting the light of the wavelength λ2 and λ3, the thicknesses of the dielectric layers are set so as to most effectively transmit the light of the wavelength λ1 and to most effectively reflect the light of the wavelengths λ2 and λ3.

With such a configuration, both of the light emitted by the second semiconductor light emitting element 314 in the direction toward the mounting substrate 301 and the light emitted by the third semiconductor light emitting element 315 in the direction toward the mounting substrate 301 can be reflected by the wide-range dielectric multilayer reflection film 406 provided below the second semiconductor light emitting element 314. Therefore, it becomes possible to eliminate the second dielectric multilayer reflection film 317 (FIG. 5) that may interfere with the transmission of the light of the wavelength λ2 if the wavelengths λ2 and λ3 are close to each other.

Accordingly, the lights emitted by the laminated semiconductor light emitting elements 302, 314 and 315 can be effectively taken out from the top surface of the third semiconductor light emitting element 315, and therefore the semiconductor light emitting device 400 and the image display apparatus 1500 can provide high brightness.

As described above, according to the fourth embodiment of the present invention, the lights emitted by the laminated semiconductor light emitting elements can be effectively taken out from the top surface of the topmost semiconductor light emitting element, and therefore it becomes possible to obtain the semiconductor light emitting device and the image display apparatus providing high brightness.

In the above described first to fourth embodiments, three semiconductor light emitting elements are laminated. However, the number of laminated semiconductor light emitting elements is not limited to three, but can be two or four or more. Further, the wavelengths of the respective semiconductor light emitting elements are not limited to those described above, but can be suitably arranged.

The above described embodiments are drawn to the image display apparatuses (as examples of an image forming apparatus) using the semiconductor light emitting devices arranged in matrix (i.e., two-dimensionally). However, the present invention is also applicable to an image display apparatus using the semiconductor light emitting devices arranged in a line (i.e., one-dimensionally).

Further, the present invention is also applicable to a printing apparatus (as another example of an image forming apparatus) using the semiconductor light emitting devices as light sources.

While the preferred embodiments of the present invention have been illustrated in detail, it should be apparent that modifications and improvements may be made to the invention without departing from the spirit and scope of the invention as described in the following claims.

## Claims

1. A semiconductor light emitting device (100, 200) comprising a plurality of semiconductor light emitting elements (102, 114, 115, 214, 215) in the form of thin films laminated in a direction perpendicular to light emitting surfaces, said plurality of semiconductor light emitting elements (102, 114, 115, 214, 215) comprising:
a first semiconductor light emitting element (102) provided on a mounting substrate (101) via a reflection metal layer (103), said first semiconductor light emitting element (102) being configured to emit light of first wavelength (λ1);
a first light-transmissive planarization insulating film (113) provided so as to cover said first semiconductor light emitting element (102), said first light-transmissive planarization insulating film (113) being configured to transmit said light of said first wavelength (λ1), and having electrical insulation property, and
a second semiconductor light emitting element (114, 214) provided on said first semiconductor light emitting element (102) via said first light-transmissive planarization insulating film (113), said second semiconductor light emitting element (102) being configured to transmit said light of said first wavelength (λ1) and to emit light of second wavelength (λ2),
wherein said second semiconductor light emitting element (114, 214) has a first semiconductor multilayer reflection film (116, 207) provided on a side facing said first semiconductor light emitting element (102), said first semiconductor multilayer reflection film (116, 207) being configured to transmit said light of said first wavelength (λ1) and to reflect said light of said second wavelength (λ2).

2. The semiconductor light emitting device (100) according to claim 1, further comprising:
a second light-transmissive planarization insulating film (118) provided so as to cover said second semiconductor light emitting element (114), said second light-transmissive planarization insulating film (118) being configured to transmit said lights of said first wavelength (λ1) and said second wavelength (λ2), and having electrical insulation property, and
a third semiconductor light emitting element (115) provided on said second semiconductor light emitting element (114) via said second light-transmissive planarization insulating film (118), said third semiconductor light emitting element (115) being configured to transmit said lights of said first wavelength (λ1) and said second wavelength (λ2) and to emit light of third wavelength (λ3),
wherein said third semiconductor light emitting element (115) has a second semiconductor multilayer reflection film (117) provided on a side facing said second semiconductor light emitting element (114), said second semiconductor multilayer reflection film (117) being configured to transmit said lights of said first wavelength (λ1) and said second wavelength (λ2) and to reflect said light of said third wavelength (λ3).

3. The semiconductor light emitting device (100) according to claim 1 or 2, further comprising:
another light-transmissive planarization insulating film (118) provided so as to cover one (114) of said plurality of semiconductor light emitting elements, said another light-transmissive planarization insulating film (118) being configured to transmit incident light from said mounting substrate (101) side, and having electrical insulation property, and
another semiconductor light emitting element (115) provided on said one (114) of said plurality of semiconductor light emitting elements (103, 114, 115) via said another light-transmissive planarization insulating film (118), said another semiconductor light emitting element (115) being configured to transmit incident light from said mounting substrate (101) side and to emit light of predetermined wavelength,
wherein said another semiconductor light emitting element (115) has another semiconductor multilayer reflection film (117) provided on a side facing said one (114) of said plurality of semiconductor light emitting elements, said another semiconductor multilayer reflection film (117) being configured to transmit said incident light and to reflect said light emitted by said another semiconductor light emitting element (115),
wherein said another semiconductor multilayer reflection film (117) includes a plurality of layers.

4. The semiconductor light emitting device (100, 200) according to any one of claims 1 to 3, wherein said first semiconductor light emitting element (102) has a contact layer (104a) on a side facing said mounting substrate (101), and
wherein said contact layer (104a) of said first semiconductor light emitting element (102) is bonded onto a surface of said reflection metal layer (103) by means of Intermolecular force, eutectic bonding or adhesive agent that transmits said light of said first wavelength (λ1).

5. The semiconductor light emitting device (100, 200) according to any one of claims 1 to 4, wherein said second semiconductor light emitting element (114, 214) has a contact layer (104b) provided on a side facing said first light-transmissive planarization insulating film (113), and
wherein said contact layer (104b) of said second semiconductor light emitting element (114, 214) is bonded onto a surface of said first light-transmissive planarization insulating film (113) by means of intermolecular force, eutectic bonding or adhesive agent that transmits said light of said first wavelength (λ1).

6. The semiconductor light emitting device (100) according to claim 3, wherein said another semiconductor light emitting element (115) has a contact layer (104c) provided on a side of said another semiconductor multilayer reflection film (117) facing said another light-transmissive planarization insulating film (118), and
wherein said contact layer (104c) of said another semiconductor light emitting element (115) is bonded onto a surface of said another light-transmissive planarization insulating film (118) by means of intermolecular force, eutectic bonding or adhesive agent that transmits said light emitted by at least one (103, 114) of said plurality of semiconductor light emitting elements provided below said another semiconductor light emitting element (115).

7. The semiconductor light emitting device (100) according to claim 6, wherein said first semiconductor multilayer reflection film (117) is configured to reflect said light of said second wavelength (λ2) and light emitted by said another semiconductor light emitting element (115), and to transmit said light of said first wavelength (λ1).

8. A semiconductor light emitting device (300, 400) comprising a plurality of semiconductor light emitting elements (302, 314, 315) in the form of thin films laminated in a direction perpendicular to light emitting surfaces, said plurality of semiconductor light emitting elements (302, 31.4, 315) comprising:
a first semiconductor light emitting element (302) provided on a mounting substrate (301) via a reflection metal layer (303), said first semiconductor light emitting element (302) being configured to emit light of first wavelength (λ1);
a first light-transmissive planarization insulating film (313) provided on said first semiconductor light emitting element (302), said first light-transmissive planarization insulating film (313) being configured to transmit said light of said first wavelength (λ1), and having electrical insulation property;
a first dielectric multilayer reflection film (316) provided on said first light-transmissive planarization insulating film (313), said first dielectric multilayer reflection film (316) being configured to transmit said light of said first wavelength (λ1), and having electrical insulation property;
a second semiconductor light emitting element (314) provided on said first light-transmissive planarization insulating film (313) via said first dielectric multilayer reflection film (316), said second semiconductor light emitting element (314) being configured to transmit said light of said first wavelength (λ1) and to emit light of second wavelength (λ2), and
wherein said first dielectric multilayer reflection film (316) is configured to transmit said light of said first wavelength (λ1) and to reflect said light of said second wavelength. (λ2).

9. The semiconductor light emitting device (300) according to claim 8, further comprising:
a second light-transmissive planarization insulating film (318) provided so as to cover said second semiconductor light emitting element (314), said second light-transmissive planarization insulating film (318) being configured to transmit said lights of said first wavelength (λ1) and said second wavelength (λ2), and having electrical insulation property;
a second dielectric multilayer reflection film (317) provided on said second light-transmissive planarization insulating film (318), said second dielectric multilayer reflection film (317) having electrical insulation property, and
a third semiconductor light emitting element (315) provided on said second light-transmissive planarization insulating film (318) via said second dielectric multilayer reflection film (317), said third semiconductor light emitting element (315) being configured to transmit said lights of said first wavelength (λ1) and said second wavelength (λ2) and to emit light of third wavelength (λ3),
wherein said second dielectric multilayer reflection film (317) is configured to transmit said lights of said first wavelength (λ1) and said second wavelength (λ2) and to reflect said light of said third wavelength (λ3).

10. The semiconductor light emitting device (300) according to claim 8 or 9, further comprising:
another light-transmissive planarization insulating film (318) provided so as to cover one (314) of said plurality of semiconductor light emitting elements (302, 314, 315), said another light-transmissive planarization insulating film (318) being configured to transmit incident light from said mounting substrate (301) side, and having electrical insulation property;
another dielectric multilayer reflection film (317) provided on said another light-transmissive planarization insulating film (318), and having electrical insulation property;
another semiconductor light emitting element (315) provided on said another light-transmissive planarization insulating film (318) via said another dielectric multilayer reflection film (317), said another semiconductor light emitting element (315) being configured to transmit incident light from said mounting substrate (301) side and to emit light of predetermined wavelength,
wherein said another semiconductor multilayer reflection film (317) being configured to transmit said incident light from said mounting substrate (301) side and to reflect said light emitted by said another semiconductor light emitting element (315).

11. The semiconductor light emitting device (300, 400) according to any one of claims 8 to 10, wherein said first semiconductor light emitting element (302) has a contact layer (304a) on a side facing said mounting substrate (301), and
wherein said contact layer (304a) of said first semiconductor light emitting element (302) is bonded onto a surface of said reflection metal layer (303) by means of intermolecular force, eutectic bonding or adhesive agent that transmits said light of said first wavelength (λ1).

12. The semiconductor light emitting device (300, 400) according to any one of claims 8 to 11, wherein said second semiconductor light emitting element (314) has a contact layer (304b) provided on a side facing said first dielectric multilayer reflection film (316), and
wherein said contact layer (304b) of said second semiconductor light emitting element (314) is bonded onto a surface of said first dielectric multilayer reflection film (316) by means of intermolecular force, eutectic bonding or adhesive agent that transmits said light of said first wavelength (λ1)

13. The semiconductor light emitting device (300) according to claim 10, wherein said another semiconductor light emitting element (315) has a contact layer (304c) provided on a side facing said another dielectric multilayer reflection film (317), and
wherein said contact layer (304c) of said another semiconductor light emitting element (315) is bonded onto a surface of said another dielectric multilayer reflection film (317) by means of intermolecular force, eutectic bonding or adhesive agent that transmits said light emitted by at least one (302, 314) of said plurality of semiconductor light emitting elements (302, 314) provided below said another semiconductor light emitting element (315).

14. The semiconductor light emitting device (300) according to claim 13, wherein said first dielectric multilayer reflection film (116) is configured to reflect said light of said second wavelength (λ2) and light emitted by said another semiconductor light emitting element (315) and to transmit said light of said first wavelength (λ1)

15. The semiconductor light emitting device (100, 200, 300, 400) according to any one of claims 1 to 1.4, wherein said plurality of semiconductor light emitting elements (102, 114, 115, 214, 215, 302, 314, 315) are formed of semiconductor thin films.

16. An image forming apparatus (1500) comprising a plurality of said semiconductor light emitting devices (100, 200, 300, 400) according to any one of claims 1 to 15 arranged in matrix on said mounting substrate.
